# EUROPÄISCHE PATENTSCHRIFT

(11) **EP 3 563 481 B1**
(45) Veröffentlichungstag und Bekanntmachung des Hinweises auf die Patenterteilung: **18.11.2020**
(21) Anmeldenummer: 18704451.6
(22) Anmeldetag: 25.01.2018
(51) Int. Cl.: H03K 17/12, H03K 17/16

(54) **STEUEREINRICHTUNG ZUR ANSTEUERUNG EINER LEISTUNGSHALBLEITERKOMPONENTE SOWIE VERFAHREN ZUR ANSTEUERUNG EINER LEISTUNGSHALBLEITERKOMPONENTE**
CONTROL DEVICE FOR CONTROLLING A POWER SEMICONDUCTOR COMPONENT AND METHOD FOR CONTROLLING SAID POWER SEMICONDUCTOR COMPONENT
DISPOSITIF DE COMMANDE D'UN COMPOSANT À SEMI-CONDUCTEUR DE PUISSANCE ET PROCÉDÉ DE COMMANDE D'UN COMPOSANT À SEMI-CONDUCTEUR DE PUISSANCE

(30) Priorität: 14.02.2017 EP 17156008
(43) Veröffentlichungstag der Anmeldung: 06.11.2019
(73) Patentinhaber: Siemens Aktiengesellschaft, 80333 München (DE)
(72) Erfinder: MAUERSBERGER, Markus, 90427 Nürnberg (DE); SOMMER, Rainer, 91336 Heroldsbach (DE)
(86) Internationale Anmeldenummer: PCT/EP2018/051859
(87) Internationale Veröffentlichungsnummer: WO 2018/149612

(56) Entgegenhaltungen:
- EP-A1- 2 830 219
- WO-A1-02/052726
- DE-A1-102011 006 788
- DE-A1-102014 224 168

## Beschreibung

Die vorliegende Erfindung betrifft eine Steuereinrichtung zur Ansteuerung einer Leistungshalbleiterkomponente, wobei die Leistungshalbleiterkomponente zumindest zwei spannungsgesteuerte Leistungshalbleiterbauelemente aufweist, welche elektrisch parallel geschaltet sind und welche jeweils einen Steueranschluss aufweisen. Die Steuereinrichtung umfasst zumindest ein Treiberelement, mittels welchem jeweilige elektrische Spannungen an den Steueranschlüssen der Leistungshalbleiterbauelemente einstellbar sind. Darüber hinaus betrifft die vorliegende Erfindung eine Leistungshalbleiterkomponente mit einer solchen Steuereinrichtung. Schließlich betrifft die vorliegende Erfindung ein Verfahren zur Ansteuerung einer Leistungshalbleiterkomponente.

Das Interesse richtet sich vorliegend auf Leistungshalbleiterkomponenten, welche beispielsweise als Umrichter oder als Stromrichter ausgebildet sein können. Derartige Leistungshalbleiterkomponenten können beispielsweise zum Betrieb von Drehstrommaschinen eingesetzt werden. Die Leistungshalbleiterkomponenten können spannungsgesteuerte Leistungshalbleiterbauelemente aufweisen, welche beispielsweise als IGBT oder als MOSFET ausgebildet sind. Zur Leistungssteigerung einer Leistungshalbleiterkomponente ist es aus dem Stand der Technik bekannt, in der Leistungshalbleiterkomponente mehrere Leistungshalbleiterbauelemente zu verwenden und diese parallel zu schalten. Um die Leistungshalbleiterbauelemente maximal auszulasten und gleichzeitig keines der parallel geschalteten Leistungshalbleiterbauelemente zu überlasten, ist es erforderlich, dass der elektrische Strom, der während einer Leitphase durch die jeweiligen Leistungshalbleiterbauelemente fließt, zwischen den Leistungshalbleiterbauelementen gleich verteilt wird bzw. symmetriert wird.

Aus dem Stand der Technik sind ferner unterschiedliche Verfahren bekannt, um die Symmetrierung der parallel geschalteten Leistungshalbleiterbauelemente zu erreichen. Beispielsweise können unterschiedliche Impedanzen zur Symmetrierung verwendet werden. Ebenso ist das sogenannte Derating der parallel geschalteten Leistungshalbleiterbauelemente bekannt. Zudem ist es erforderlich, auf ein möglichst symmetrisches Design der Steuereinrichtung bzw. der Ansteuerschaltung sowie der Zuleitungen zu achten. Je nach Typ des Leistungshalbleiterbauelements ist es zudem erforderlich, auf eine gute thermische Kopplung bzw. Entkopplung zu achten.

Darüber hinaus ist es aus dem Stand der Technik bekannt, eine zeitliche Verschiebung der einzelnen Schaltpulse der parallel geschalteten Leistungshalbleiterbauelemente zueinander vorzusehen. Dies bedeutet insbesondere, dass einer oder mehrere der Leistungshalbleiterbauelemente früher als die anderen im Verbund eingeschaltet werden und somit mehr elektrischen Strom übernehmen. Gleiches gilt sinngemäß für den Abschaltvorgang der Leistungshalbleiterbauelemente.

Hierzu beschreibt die DE 10 2011 006 788 A1 eine Schaltungsanordnung für eine Schutzeinrichtung einer Anlage, mit elektrischen Energiequellen, welche variable Strom- und/oder Spannungsparameter aufweisen. Die Schaltungsanordnung besteht aus zumindest zwei parallel geschalteten Sicherungskanälen, welche jeweils eine Strommesseinrichtung und zumindest einen Schalter umfassen. Die Sicherungskanäle weisen derart definierte Widerstandswerte auf, dass ein Summenstrom symmetrisch zwischen den Sicherungskanälen aufgeteilt wird.

Außerdem offenbart die WO 02/052726 A1 ein Verfahren zur dynamischen Symmetrisierung einer Schaltung von Leistungshalbleiterbauelementen. Hierbei kann ein Schaltsignal zeitlich verschoben werden oder seine Amplitude erhöht werden, so dass eine Regelabweichung zwischen einem Istwert und einem vorgebbaren Sollwert verringert wird.

Aus der DE 10 2014 224 168 A1 ist ein Verfahren zum Betreiben von parallel geschalteten Leistungshalbleiterschaltern bekannt. Hierbei wird eine Sollgröße für einen Gesamtgatevorwiderstand des Leistungshalbleiterschalters bestimmt und der Gesamtgatevorwiderstand in Abhängigkeit von der Sollgröße gebildet.

Ferner beschreibt die EP 2 830 219 A1 eine Vorrichtung umfassend einen Controller, mittels welchem Ströme, die aus Transistoren fließen identifiziert werden können. Dabei können Charakteristika der Transistoren so eingestellt werden, dass die Ströme einen gewünschten Wert aufweisen.

Es ist Aufgabe der vorliegenden Erfindung, eine Lösung aufzuzeigen, wie eine Leistungshalbleiterkomponente mit zumindest zwei parallel geschalteten Leistungshalbleiterbauelementen auf einfache Weise zuverlässiger betrieben werden kann.

Diese Aufgabe wird erfindungsgemäß durch eine Steuereinrichtung, durch eine Leistungshalbleiterkomponente sowie durch ein Verfahren mit den Merkmalen gemäß den jeweiligen unabhängigen Ansprüchen gelöst. Vorteilhafte Weiterbildungen der vorliegenden Erfindung sind Gegenstand der abhängigen Ansprüche.

Eine erfindungsgemäße Steuereinrichtung dient zur Ansteuerung einer Leistungshalbleiterkomponente. Dabei weist die Leistungshalbleiterkomponente zumindest zwei spannungsgesteuerte Leistungshalbleiterbauelemente, welche elektrisch parallel geschaltet sind und welche jeweils einen Steueranschluss aufweisen, auf. Die Steuereinrichtung umfasst zumindest ein Treiberelement, mittels welchem jeweilige elektrische Spannungen an den Steueranschlüssen der Leistungshalbleiterbauelemente einstellbar sind. Darüber hinaus weist die Steuereinrichtung eine Messeinheit auf, welche dazu ausgelegt ist, jeweilige elektrische Ströme, welche durch die Leistungshalbleiterbauelemente fließen, zu erfassen. Darüber hinaus ist das zumindest eine Treiberelement dazu ausgelegt, eine Höhe und/oder einen zeitlichen Verlauf der jeweiligen elektrischen Spannungen in Abhängigkeit von den jeweiligen elektrischen Strömen einzustellen. Ferner ist das zumindest eine Treiberelement dazu ausgelegt ist, eine zeitliche Änderung der jeweiligen an den Steueranschlüssen anliegenden elektrischen Spannungen bei einem Einschalten und/oder bei einem Ausschalten der Leistungshalbleiterbauelemente in Abhängigkeit von den jeweiligen elektrischen Strömen einzustellen.

Die Steuereinrichtung kann für eine Leistungshalbleiterkomponente verwendet werden, welche beispielsweise in einem Stromrichter bzw. einem Umrichter verwendet wird. Mit der Steuereinrichtung können Leistungshalbleiterkomponenten angesteuert werden, welche zumindest zwei Leistungshalbleiterbauelemente aufweisen, welche elektrisch parallel geschaltet sind. Die Leistungshalbleiterbauelemente weisen jeweils einen Steueranschluss auf, an welchem eine elektrische Spannung angelegt werden kann. Dieser Steueranschluss kann auch als Gate bzw. als Gate-Anschluss bezeichnet werden. Die Leistungshalbleiterbauelemente können insbesondere als IGBT, als JFET oder als MOSFET ausgebildet sein. Diese Leistungshalbleiterbauelemente werden innerhalb der Leistungshalbleiterkomponente als steuerbare Schalter verwendet. Die Steuereinrichtung weist zumindest ein Treiberelement auf, welches mit den jeweiligen Steueranschlüssen der Leistungshalbleiterbauelemente elektrisch verbunden ist. Das Treiberelement kann auch als Treiber oder als Gate-Unit bezeichnet werden. Mithilfe des Treiberelements kann eine elektrische Spannung ausgegeben werden und an den jeweiligen Steueranschlüssen der Leistungshalbleiterbauelemente angelegt werden.

Gemäß einem wesentlichen Aspekt der vorliegenden Erfindung ist es nun vorgesehen, dass die Steuereinrichtung eine Messeinheit aufweist, mittels welcher die jeweiligen elektrischen Ströme, welche durch die Leistungshalbleiterbauelemente fließen, erfasst werden können. Beispielsweise kann die Messeinheit für jedes Leistungshalbleiterbauelement einen Stromsensor aufweisen. Es kann auch ein Shunt oder Widerstand vorgesehen sein, an welchem zum Bestimmen des elektrischen Stroms der Spannungsabfall gemessen wird. Somit kann der elektrische Strom, welcher während der Leitphase durch das jeweilige Leistungshalbleiterbauelement fließt, erfasst werden. Das zumindest eine Treiberelement ist dazu ausgelegt, die jeweiligen elektrischen Spannungen, die an den Steueranschlüssen der Leistungshalbleiterbauelemente angelegt werden, in Abhängigkeit von den jeweiligen Strömen, die durch die Leistungshalbleiterbauelemente fließen, anzupassen.

Dabei kann mit dem Treiberelement einerseits die Höhe der elektrischen Spannung angepasst werden. Mithilfe des Treiberelements können also Spannungen unterschiedlicher Höhe bzw. unterschiedliche elektrische Spannungen variabel ausgegeben werden. Die elektrische Spannung kann also relativ frei gewählt werden. Insbesondere ist es nicht vorgesehen, dass die elektrische Spannung nicht nur auf zwei oder drei fixe Werte eingestellt werden kann. Alternativ oder zusätzlich kann mithilfe des Treiberelements der zeitliche Verlauf der Spannung gesteuert werden. Auf diese Weise kann die elektrische Spannung an dem jeweiligen Leistungshalbleiterbauelement in Abhängigkeit von dem Strom, der aktuell durch das Leistungshalbleiterbauelement fließt, angepasst werden. Somit kann beispielsweise erreicht werden, dass die jeweiligen Ströme, welche durch die Leistungshalbleiterbauelemente der Leistungshalbleiterkomponente fließen, im Wesentlichen gleich sind. Diese ermöglicht eine Symmetrierung der Ströme, welche durch die Leistungshalbleiterbauelemente fließen. Auf diese Weise kann eine Überlastung der Leistungshalbleiterbauelemente vermieden werden. Insgesamt wird somit ein zuverlässiger Betrieb der Leistungshalbleiterkomponente ermöglicht.

Außerdem ist die Treibereinrichtung dazu ausgelegt, eine zeitliche Änderung der jeweiligen an den Steueranschlüssen anliegenden elektrischen Spannungen in Abhängigkeit von den jeweiligen elektrischen Strömen einzustellen. Hierbei ist es vorgesehen, dass die zeitliche Änderung der jeweiligen elektrischen Spannungen beim Einschalten und/oder beim Ausschalten eingestellt wird. Somit kann eine dynamische Parallelisierung beim Einschalten und/oder beim Ausschalten erreicht werden. Für den Verlauf der elektrischen Spannung können also unterschiedliche Zeitverläufe vorgegeben werden. Ein Leistungshalbleiterbauelement kann also schneller eingeschaltet werden als das andere. Dies gilt auch für das Ausschalten der Leistungshalbleiterbauelemente. Dies kann beispielsweise dadurch erreicht werden, dass die Steilheit der Flanken der elektrischen Spannung angepasst wird. Dies eignet sich bevorzugt zur Kompensation von unterschiedlichen Streuinduktivitäten. Bezüglich der jeweiligen elektrischen Spannung, welchen an den Steueranschlüssen anliegt, können die Höhe der elektrischen Spannung und/oder der zeitliche Verlauf und/oder der Startzeitpunkt und/oder der Endzeitpunkt angepasst werden.

Zudem ist das zumindest eine Treiberelement dazu ausgelegt ist, die jeweiligen elektrischen Spannungen anhand von während eines vorhergehenden Betriebs des Leistungsmoduls eingestellten Spannungen einzustellen. Die jeweiligen Spannungen, die an den Leistungshalbleiterbauelementen im Betrieb der Leistungshalbleiterkomponente angelegt werden, können in einem entsprechenden Speicher der Steuereinrichtung hinterlegt werden. Somit wird es ermöglicht, dass die konkreten Schalteigenschaften, also der Spannungsverlauf, die Spannungsänderung, die Spannungshöhe und/oder die Schaltzeitpunkte, auf Grundlage der vorhergehenden Einstellungen bestimmt werden. Darüber hinaus werden die elektrischen Ströme, welche durch die Leistungshalbleiterbauelemente bei bestimmten Einstellungen bezüglich der Spannung fließen, gespeichert. Somit kann ein lernfähiges System bereitgestellt werden.

Bevorzugt ist das zumindest eine Treiberelement dazu ausgelegt, die jeweiligen elektrischen Spannungen derart einzustellen, dass die jeweiligen elektrischen Ströme im Wesentlichen gleich sind. Durch die Spannung, die an dem Steueranschluss des Leistungshalbleiterbauelements angelegt wird, kann der elektrische Widerstand des Leistungshalbleiterbauelements gesteuert werden. Dabei sorgt eine verhältnismäßig hohe Spannung an dem Steueranschluss für einen geringen elektrischen Widerstand. Eine verhältnismäßige geringe elektrische Spannung sorgt für einen hohen elektrischen Widerstand. Auf diese Weise kann der elektrische Strom, der durch das jeweilige Leistungshalbleiterbauelement fließt, entsprechend beeinflusst werden. Auf diese Weise kann eine Überlastung oder Beschädigung der jeweiligen Leistungshalbleiterbauelemente verhindert werden.

Gemäß einer Ausführungsform ist das zumindest eine Treiberelement dazu ausgelegt, jeweilige Startzeitpunkte und Endzeitpunkt, zwischen denen die elektrische Spannung an den Steueranschlüssen anliegt, in Abhängigkeit von den jeweiligen elektrischen Strömen einzustellen. Mit anderen Worten können die einzelnen Schaltpulse der parallel geschalteten Leistungshalbleiterbauelemente zueinander verschoben werden. Somit kann die elektrische Spannung an einem oder mehreren der Leistungshalbleiterbauelemente früher als an den anderen Leistungshalbleiterbauelementen angelegt werden. Gleiches gilt für den Endzeitpunkt, ab welchem die elektrische Spannung nicht mehr an den jeweiligen Steueranschlüssen anliegt. Auf diese Weise kann die Stromverteilung innerhalb Leistungshalbleiterbauelemente gesteuert werden.

In einer Ausgestaltung weist die Steuereinrichtung ein Treiberelement auf, welches für jedes der Leistungshalbleiterbauelemente einen Ausgang und zumindest einen Eingang zum Empfangen von Messwerten, welche die jeweiligen elektrischen Ströme beschreiben, aufweist. Gemäß dieser Ausführungsform weist die Steuereinrichtung ein einziges Treiberelement auf. Dabei ist jeder Ausgang des Treiberelements mit einem Steueranschluss einer Leistungshalbleiterkomponente verbunden. Zudem kann das Treiberelement von der Messeinrichtung die Messwerte empfangen, welche die jeweiligen elektrischen Ströme durch die Leistungshalbleiterbauelemente beschreiben. Mithilfe des Treiberelements können dann die Messwerte miteinander verglichen werden und somit die elektrischen Spannungen für die jeweiligen Leistungshalbleiterbauelemente bestimmt werden.

Gemäß einer alternativen Ausführungsform weist die Steuereinrichtung für jedes der Leistungshalbleiterbauelemente ein Treiberelement auf, wobei jedes der Treiberelemente einen Ausgang für das Leistungshalbleiterbauelement aufweist. Bei dieser Ausgestaltung ist jedem der Leistungshalbleiterbauelemente ein eigenes Treiberelement zugeordnet. Jedes Treiberelement kann am Ausgang die Spannung für das Leistungshalbleiterbauelement bereitstellen. Zudem weist jedes Treiberelement einen Eingang auf, um den Messwert, der den elektrischen Strom durch das Leistungshalbleiterbauelement beschreibt, zu empfangen. Dabei ist es insbesondere vorgesehen, dass die Steuereinrichtung zumindest eine Kommunikationseinheit zum Übertragen der jeweiligen Messwerte zwischen den Treiberelementen aufweist. Beispielsweise können die jeweiligen Treiberelemente mittels der Kommunikationseinheit zur Datenübertragung verbunden sein. Dabei kann die Datenübertragung über ein Kabel bzw. eine Datenleitung, optisch oder über eine Funkverbindung erfolgen.

Hierbei kann es zu dem vorgesehen sein, dass die jeweiligen Ströme, welche durch die Leistungshalbleiterbauelemente fließen, mit einem Schwellenwert verglichen werden. Falls dieser Schwellwert überschritten wird, können sich die jeweiligen Treiberelemente untereinander abstimmen und die jeweiligen Spannungen, die mit den jeweiligen Treiberelement ausgegeben werden, so angepasst werden, dass die Stromaufteilung zwischen den Leistungshalbleiterbauelementen wieder gleich ist.

Gemäß einer weiteren Ausgestaltung weist die Steuereinrichtung eine zentrale Recheneinheit zum Empfangen von Messwerten, welche die jeweiligen elektrischen Ströme beschreiben, und zumindest eine Kommunikationseinheit zum Übertragen der jeweiligen Messwerte zu den Treiberelementen auf. Es kann also auch eine übergeordnete bzw. zentrale Recheneinheit vorgesehen sein, mittels welcher die jeweiligen Messwerte empfangen werden können. Diese Werte können dann über die Kommunikationseinheit - wie zuvor beschrieben - an die jeweiligen Treiberelemente übertragen werden.

Grundsätzlich kann mit dem zumindest einen Treiberelement die Spannung für das Leistungshalbleiterbauelement in Abhängigkeit von dem Strom durch das Leistungshalbleiterbauelement bestimmt werden. Wenn der Strom durch das Leistungshalbleiterbauelement zu hoch ist, kann die Spannung verringert werden. Falls der Strom durch das Leistungshalbleiterbauelement zu niedrig ist, kann die Spannung erhöht werden. In dem Treiberelement können Kennlinien oder Tabellen hinterlegt sein, welche die auszugebende Spannung in Abhängigkeit von dem Strom beschreiben.

Wie zuvor beschrieben, kann die Steuereinrichtung dazu verwendet werden, parallel geschaltete Leistungshalbleiterbauelemente anzusteuern. Diese Leistungshalbleiterbauelemente können auch als Chips bezeichnet werden. Zudem kann die die Steuereinrichtung dazu verwendet werden, parallel geschaltete Leistungshalbleitermodule oder Umrichter anzusteuern. In Leistungsmodulen sind oft einzelne Chips parallelgeschaltet und so nach außen geführt, dass das einzelne Leistungshalbleitermodulmodul wiederum die gleichen Schnittstellen aufweist wie ein Leistungshalbleiterbauelement. Beispielsweise kann das Leistungshalbleitermodul einen Gate-Anschluss, einen Kollektor-Anschluss und/oder einen Emitter-Anschluss wie ein einzelner Leistungshalbleiter aufweisen. Der Umrichter besteht wiederum aus einzelnen Leistungshalbleitern und/oder Leistungshalbleitermodulen sowie zusätzlichen Komponenten, wie beispielsweise Kondensatoren, Stromversorgungen und dergleichen.

Eine erfindungsgemäße Leistungshalbleiterkomponente umfasst zumindest zwei spannungsgesteuerte Leistungshalbleiterbauelemente und eine erfindungsgemäße Steuereinrichtung zum Ansteuern der zumindest zwei spannungsgesteuerten Leistungshalbleiterbauelemente. Dabei ist es bevorzugt vorgesehen, dass die Leistungshalbleiterkomponente Teil eines Stromrichters bzw. Umrichters ist. Die zumindest zwei Leistungshalbleiterbauelemente sind bevorzugt als IGBT, als JFET oder als MOSFET ausgebildet.

Ein erfindungsgemäßes Verfahren dient zum Ansteuern einer Leistungshalbleiterkomponente, wobei die Leistungshalbleiterkomponente zumindest zwei spannungsgesteuerte Leistungshalbleiterbauelemente aufweist, welche elektrisch parallel geschaltet sind und welche jeweils einen Steueranschluss aufweisen. Bei dem Verfahren werden mittels zumindest eines Treiberelements jeweilige elektrische Spannungen an den Steueranschlüssen der Leistungshalbleiterbauelemente eingestellt. Darüber hinaus ist es vorgesehen, dass mittels einer Messeinheit jeweilige elektrische Ströme, welche durch die Leistungshalbleiterbauelemente fließen, erfasst werden und eine Höhe und/oder ein zeitlicher Verlauf der jeweiligen elektrischen Spannungen mittels des zumindest einen Treiberelements in Abhängigkeit von den jeweiligen elektrischen Strömen eingestellt wird. Zudem ist es vorgesehen, dass mittels des zumindest einen Treiberelements eine zeitliche Änderung der jeweiligen an den Steueranschlüssen anliegenden elektrischen Spannungen bei einem Einschalten und/oder bei einem Ausschalten der Leistungshalbleiterbauelemente in Abhängigkeit von den jeweiligen elektrischen Strömen eingestellt wird.

Die mit Bezug auf die erfindungsgemäße Steuereinrichtung vorgestellten bevorzugten Ausführungsformen und deren Vorteile gelten entsprechend für die erfindungsgemäße Leistungshalbleiterkomponente sowie das erfindungsgemäße Verfahren.

Die Erfindung wird nun anhand von bevorzugten Ausführungsbeispielen sowie unter Bezugnahme auf die beigefügten Zeichnungen näher erläutert. Dabei zeigen:
- FIG 1: eine Leistungshalbleiterkomponente gemäß einer Ausführungsform der Erfindung, welche zwei spannungsgesteuerte Leistungshalbleiterbauelemente sowie eine Steuereinrichtung aufweist;
- FIG 2: einen zeitlichen Verlauf der jeweiligen Ströme, welche durch die Leistungshalbleiterbauelemente fließen;
- FIG 3: jeweilige elektrische Spannungen, welche in Abhängigkeit von den Strömen an Steueranschlüssen der Leistungshalbleiterbauelemente angelegt werden;
- FIG 4: jeweilige elektrische Spannungen, welche in Abhängigkeit von den Strömen an Steueranschlüssen der Leistungshalbleiterbauelemente angelegt werden gemäße einer weiteren Ausführungsform;
- FIG 5: eine Leistungshalbleiterkomponente gemäß einer weiteren Ausführungsform; und
- FIG 6: eine Leistungshalbleiterkomponente gemäß einer weiteren Ausführungsform.

In den Figuren werden gleiche und funktionsgleiche Elemente mit den gleichen Bezugszeichen versehen.

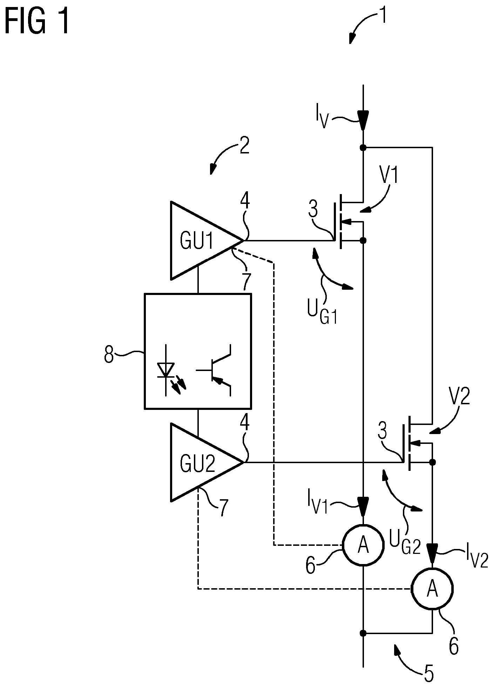

FIG 1 zeigt eine Leistungshalbleiterkomponente 1 gemäß einer Ausführungsform der vorliegenden Erfindung in einer schematischen Darstellung. Die Leistungshalbleiterkomponente 1 kann Teil eines Stromrichters oder eines Umrichters sein. Die Leistungshalbleiterkomponente 1 umfasst ein erstes Leistungshalbleiterbauelement V1 und ein zweites Leistungshalbleiterbauelement V2. Die Leistungshalbleiterbauelemente V1, V2 sind vorliegend als MOSFETs ausgebildet. Die Leistungshalbleiterbauelemente V1, V2 sind elektrisch parallel geschaltet. Vorliegend wird ein Gesamtstrom Iv auf die beiden Leistungshalbleiterbauelemente V1, V2 aufgeteilt. Somit fließt durch das erste Leistungshalbleiterbauelement V1 ein Strom Ivi und durch das zweite Leistungshalbleiterbauelement V2 fließt ein Strom I_{V2}. Im Betrieb der Leistungshalbleiterkomponente 1 ist es angestrebt, dass die elektrischen Ströme I_{V1} und I_{V2} im Wesentlichen gleich sind.

Darüber hinaus umfasst die Leistungshalbleiterkomponente 1 eine Steuereinrichtung 2 zur Ansteuerung der Leistungshalbleiterbauelemente V1, V2. Die Steuereinrichtung 2 umfasst zumindest ein Treiberelement GU1, GU2, mit dem eine jeweilige elektrische Spannung U_{G1}, U_{G2} an jeweiligen Steueranschlüssen 3 der Leistungshalbleiterbauelemente V1, V2 angelegt werden können. Die Steueranschlüsse 3 entsprechen den Gate-Anschlüssen der MOSFETs. In dem vorliegenden Beispiel ist jedem der Leistungshalbleiterbauelemente V1, V2 ein Treiberelement GU1, GU2 zugeordnet. Dabei ist dem ersten Leistungshalbleiterbauelement V1 ein erstes Treiberelement GU1 zugeordnet, wobei ein Ausgang 4 des ersten Treiberelements GU1 mit dem Steueranschluss 3 des ersten Leistungshalbleiterbauelements V1 verbunden ist. Somit kann die elektrische Spannung U_{G1} an dem Steueranschluss 3 des ersten Leistungshalbleiterbauelements V1 angelegt werden. In gleicher Weise kann mit dem zweiten Treiberelement GU2 eine elektrische Spannung U_{G2} an dem Steueranschluss 3 des zweiten Leistungshalbleiterbauelements V2 angelegt werden.

Darüber hinaus umfasst die Steuereinrichtung 2 eine Messeinheit 5, mittels welcher die jeweiligen Ströme I_{V1}, I_{V2} durch die Leistungshalbleiterbauelemente V1, V2 bestimmt werden können. Vorliegend umfasst die Messeinheit 5 zwei Stromsensoren 6, wobei jeweils ein Stromsensor 6 einem Leistungshalbleiterbauelement V1, V2 zugeordnet ist. Die jeweiligen Stromsensoren 6 sind mit jeweiligen Eingängen 7 der Treiberelemente GU1, GU2 verbunden. Somit können von den Treiberelementen GU1, GU2 jeweils Messwerte empfangen werden, welche die elektrischen Ströme I_{V1}, I_{V2} beschreiben.

Ferner umfasst die Steuereinrichtung 2 eine Kommunikationseinheit 8, mittels welcher die Treiberelemente GU1, GU2 zur Datenübertragung verbunden sind. Somit wird es ermöglicht, dass die Messwerte zwischen den Treiberelementen GU1 und GU2 ausgetauscht werden können. In Abhängigkeit von den Messwerten bzw. den Strömen I_{V1} und I_{V2} durch die Leistungshalbleiterbauelemente V1, V2 können dann die elektrischen Spannungen U_{G1} und U_{G2}, die mit den Treiberelementen GU1 und GU2 ausgegeben werden, angepasst werden.

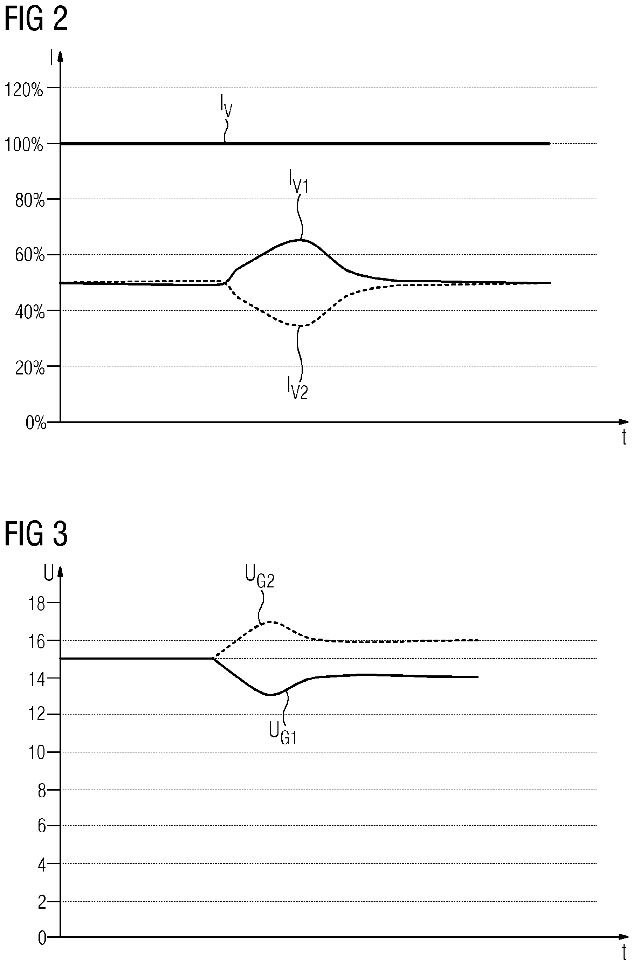

FIG 2 zeigt die jeweiligen elektrischen Ströme Ivi und I_{V2} durch die Leistungshalbleiterbauelemente V1 und V2 in Abhängigkeit von der Zeit t. Die dem Diagramm von FIG 2 ist der elektrische Strom I in Abhängigkeit von der Zeit t dargestellt. Hierbei ist zu erkennen, dass der elektrische Strom Ivi durch das erste Leistungshalbleiterbauelement V1 in Abhängigkeit von der Zeit t ansteigt und dass sich der elektrische Strom I_{V2} durch das zweite Leistungshalbleiterbauelement V2 in Abhängigkeit von der Zeit t reduziert. Die Veränderungen der elektrischen Ströme I_{V1} und I_{V2} können durch externe Einflüsse, wie Erwärmung, und durch Parameterschwankungen der einzelnen Leistungshalbleiterbauelemente V1, V2 begründet sein.

Diese Änderung der Aufteilung der elektrischen Ströme I_{V1}, I_{V2} durch die Leistungshalbleiterbauelemente V1, V2 kann mithilfe der Treiberelemente GU1, GU2 anhand der Messwerte erfasst werden. In Abhängigkeit von den jeweiligen elektrischen Strömen I_{V1}, I_{V2} werden die elektrischen Spannungen U_{G1} und U_{G2}, die von den Treiberelementen GU1, GU2 ausgegeben werden, angepasst. Dies ist in FIG 3 veranschaulicht. Vorliegend wird die elektrische Spannung U_{G2} an dem zweiten Leistungshalbleiterbauelement V2 in Abhängigkeit von der Zeit t erhöht. Somit kann der elektrische Widerstand innerhalb des zweiten Leistungshalbleiterbauelements V2 reduziert werden. In gleicher Weise wird die elektrische Spannung U_{G1} an dem ersten Leistungshalbleiterbauelement V1 reduziert. Damit kann der elektrische Widerstand innerhalb des ersten Leistungshalbleiterbauelements V1 erhöht werden. Insgesamt kann somit erreicht werden, dass die Ströme I_{V1}, I_{V2}, welche durch die Leistungshalbleiterbauelemente V1 und V2 fließen, im Wesentlichen gleich sind.

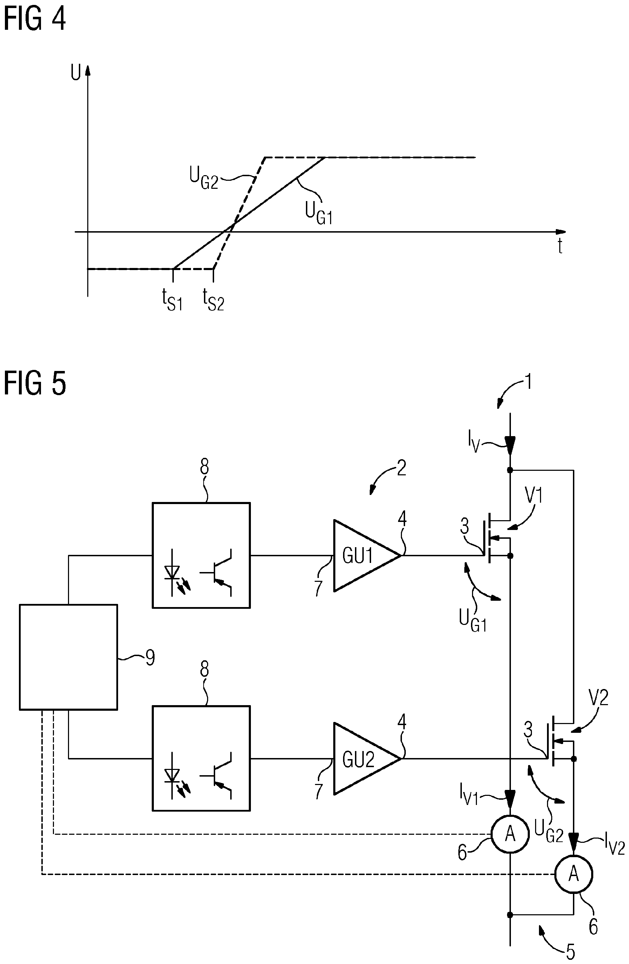

FIG 4 zeigt den Verlauf der elektrischen Spannungen U_{G1} und U_{G2} gemäß einer weiteren Ausführungsform. Hier unterscheiden sich die Spannungen U_{G1} und U_{G2} bezüglich der Startzeitpunkte tₛ₁ und tₛ₂, ab welchen diesen an den Steueranschlüssen 3 angelegt werden. Vorliegend wird zunächst die elektrische Spannung U_{G1} zu dem Startzeitpunkt tₛ₁ an dem Steueranschluss 3 angelegt. Anschließend daran wird die elektrische Spannung U_{G2} zu dem Startzeitpunkt tₛ₂ an dem Steueranschluss 3 angelegt. In gleicher Weise können Endzeitpunkte, ab denen die jeweiligen elektrischen Spannungen U_{G1} und U_{G2} nicht mehr an den Steueranschlüssen 3 angelegt werden, angepasst werden. Zudem unterscheiden sich die elektrischen Spannungen U_{G1} und U_{G2} bezüglich ihrer zeitlichen Änderungen beim Einschalten bzw. beim Anlegen. Vorliegend weisen die elektrischen Spannungen U_{G1} und U_{G2} beim Einschalten gerade Flanken mit unterschiedlicher Steilheit auf. Das zweite Leistungshalbleiterbauelement V2, an welchem die Spannung U_{G2} anliegt, wird vorliegend schneller eingeschaltet als das erste Leistungshalbleiterbauelement V1, an welchem die Spannung U_{G1} anliegt. Somit übernimmt das zweite Leistungshalbleiterbauelement V2 dynamisch mehr Strom als das erste Leistungshalbleiterbauelement V1.

FIG 5 zeigt eine Leistungshalbleiterkomponente 1 gemäß einer weiteren Ausführungsform. In diesem Fall umfasst die Steuereinrichtung 2 zusätzlich eine zentrale Recheneinheit 9. Diese zentrale Recheneinheit 9 ist zur Datenübertragung mit den jeweiligen Stromsensoren 6 verbunden. Somit kann die Recheneinheit 9 die jeweils mit den Stromsensoren 6 bereitgestellten Messwerte empfangen. Diese Messwerte können über entsprechende Kommunikationseinheiten 8 an die Treiberelemente GU1, GU2 übertragen werden.

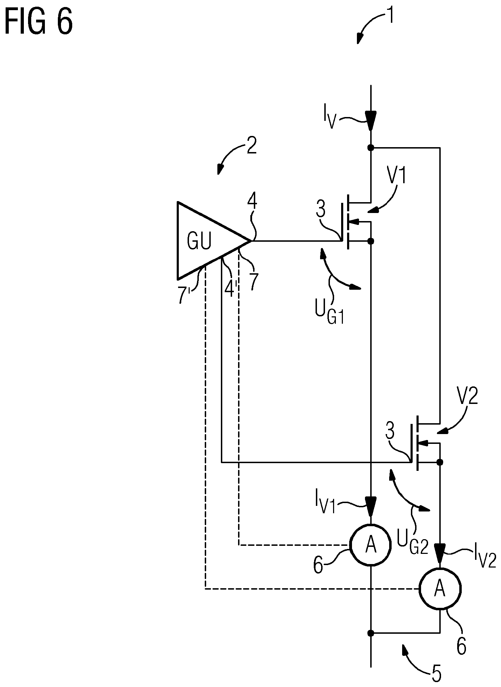

FIG 6 zeigt die Leistungshalbleiterkomponente 1 gemäß einer weiteren Ausgestaltung. In diesem Fall weist die Steuereinrichtung 2 ein einziges Treiberelement GU auf. Vorliegend weist das Treiberelement GU einen ersten Ausgang 4, welcher mit dem ersten Leistungshalbleiterbauelement V1 verbunden ist, sowie einen zweiten Ausgang 4', der mit dem zweiten Leistungshalbleiterbauelement V2 verbunden ist, auf. Des Weiteren weist das Treiberelement GU jeweilige Eingänge 7 und 7' auf, die mit den jeweiligen Stromsensoren 6 verbunden sind.

Grundsätzlich kann es vorgesehen sein, dass die Leistungshalbleiterkomponente 1 eine Mehrzahl von Leistungshalbleiterbauelementen V1, V2 aufweist, welche parallel geschaltet sind. Mit den jeweiligen Treiberelementen GU, GU1, GU2 kann die Höhe und/oder der zeitliche Verlauf der jeweiligen elektrischen Spannungen U_{G1}, U_{G2} in Abhängigkeit von den Strömen I_{V1}, I_{V2} angepasst werden. Durch die Anpassung der Spannungshöhe können unterschiedliche Durchlasseigenschaften der Leistungshalbleiterbauelemente V1, V2 kompensiert werden. Dabei kann es ferner vorgesehen sein, dass die Einschaltpulse ts1, ts2 und/oder die Ausschaltpulse zum Anlegen der jeweiligen elektrischen Spannungen U_{G1}, U_{G2} an den Leistungshalbleiterbauelement V1, V2 zeitlich verschoben werden. Zudem kann die zeitliche Änderung der elektrischen Spannungen U_{G1}, U_{G2} in Abhängigkeit von den Strömen I_{V1}, I_{V2} angepasst werden. Auf diese Weise können unterschiedliche Streuinduktivitäten kompensiert werden. Darüber hinaus kann das Verfahren derart angewendet werden, dass die konkreten Schalteigenschaften, also der Spannungsverlauf, die Spannungshöhe und/oder die Schaltzeitpunkte, aus Strominformationen von vorhergegangenen Pulsen gewonnen werden. Somit kann ein lernendes Verfahren bereitgestellt werden.

## Patentansprüche

1. Steuereinrichtung (2) zur Ansteuerung einer Leistungshalbleiterkomponente (1), wobei die Leistungshalbleiterkomponente (1) zumindest zwei spannungsgesteuerte Leistungshalbleiterbauelemente (V1, V2) aufweist, welche elektrisch parallel geschaltet sind und welche jeweils einen Steueranschluss (3) aufweisen, wobei die Steuereinrichtung (2) zumindest ein Treiberelement (GU, GU1, GU2) umfasst, mittels welchem jeweilige elektrische Spannungen (U_{G1}, U_{G2}) an den Steueranschlüssen (3) der Leistungshalbleiterbauelemente (V1, V2) einstellbar sind, wobei die Steuereinrichtung (2) eine Messeinheit (5) aufweist, welche dazu ausgelegt ist, jeweilige elektrische Ströme (I_{V1}, I_{V2}), welche durch die jeweiligen Leistungshalbleiterbauelemente (V1, V2) fließen, zu erfassen, und dass das zumindest eine Treiberelement dazu ausgelegt ist, eine Höhe und/oder einen zeitlichen Verlauf der jeweiligen elektrischen Spannungen (U_{G1}, U_{G2}) in Abhängigkeit von den jeweiligen elektrischen Strömen (I_{V1}, I_{V2}) einzustellen, **dadurch gekennzeichnet , dass** das zumindest eine Treiberelement (GU, GU1, GU2) dazu ausgelegt ist, eine zeitliche Änderung der jeweiligen an den Steueranschlüssen (3) anliegenden elektrischen Spannungen (U_{G1}, U_{G2}) durch Anpassen einer Steilheit von Flanken der jeweiligen elektrischen Spannungen (U_{G1}, U_{G2}) bei einem Einschalten und/oder bei einem Ausschalten der Leistungshalbleiterbauelemente (V1, V2) in Abhängigkeit von den jeweiligen elektrischen Strömen (I_{V1}, I_{V2}) einzustellen, wobei die elektrischen Spannungen (U_{G1}, U_{G2}) beim Einschalten und/oder beim Ausschalten gerade Flanken aufweisen, wobei das zumindest eine Treiberelement (GU, GU1, GU2) dazu ausgelegt ist, die jeweiligen elektrischen Spannungen (U_{G1}, U_{G2}) anhand von während eines vorhergehenden Betriebs des Leistungsmoduls (1) eingestellten Spannungen einzustellen, wobei die elektrischen Ströme (I_{V1}, I_{V2}), welche durch die Leistungshalbleiterbauelemente (V1, V2) bei bestimmten Einstellungen bezüglich der elektrischen Spannungen (U_{G1}, U_{G2}) fließen, gespeichert sind und das zumindest eine Treiberelement (GU, GU1, GU2) dazu ausgelegt ist, die Änderung der jeweiligen elektrischen Spannungen (U_{G1}, U_{G2}) auf Grundlage der vorhergehenden Einstellungen zu bestimmen.

2. Steuereinrichtung (2) nach Anspruch 1, wobei das zumindest eine Treiberelement (GU, GU1, GU2) dazu ausgelegt ist, die jeweiligen elektrischen Spannungen (U_{G1}, U_{G2}) derart einzustellen, dass die jeweiligen elektrischen Ströme (I_{V1}, I_{V2}) im Wesentlichen gleich sind.

3. Steuereinrichtung (2) nach Anspruch 1 oder 2, wobei das zumindest eine Treiberelement (GU,GU1,GU2) dazu ausgelegt ist, jeweilige Startzeitpunkte (tₛ₁, tₛ₂) und Endzeitpunkt, zwischen denen die elektrische Spannung (U_{G1}, U_{G2}) an den Steueranschlüssen (3) anliegt, in Abhängigkeit von den jeweiligen elektrischen Strömen (I_{V1}, I_{V2}) einzustellen.

4. Steuereinrichtung (2) nach einem der vorhergehenden Ansprüche, wobei die Steuereinrichtung (2) ein Treiberelement (GU) aufweist, welches für jedes der Leistungshalbleiterbauelemente (V1, V2) einen Ausgang (4,4') und zumindest einen Eingang (7,7') zum Empfangen von Messwerten, welche die jeweiligen elektrischen Ströme (I_{V1}, I_{V2}) beschreiben, aufweist.

5. Steuereinrichtung (2) nach einem der Ansprüche 1 bis 3, wobei die Steuereinrichtung (2) für jedes der Leistungshalbleiterbauelemente (V1, V2) ein Treiberelement (GU1, GU2) aufweist, wobei jedes der Treiberelemente (GU1, GU2) einen Ausgang (4) für das Leistungshalbleiterbauelement (V1, V2) aufweist.

6. Steuereinrichtung (2) nach Anspruch 5, wobei jedes der Treiberelemente (GU1, GU2) einen Eingang (7) zum Empfangen eines Messwerts, welcher den elektrischen Strom (Iᵥ₁, Iᵥ₂) durch das Leistungshalbleiterbauelement (V1, V2) beschreibt, aufweist und wobei die Steuereinrichtung (2) zumindest eine Kommunikationseinheit (8) zum Übertragen der jeweiligen Messwerte zwischen den Treiberelementen (GU1, GU2) aufweist.

7. Steuereinrichtung (2) nach Anspruch 5, wobei die Steuereinrichtung (2) eine zentrale Recheneinheit (9) zum Empfangen von Messwerten, welche die jeweiligen elektrischen Ströme (I_{V1}, I_{V2}) beschreiben, und zumindest eine Kommunikationseinheit (8) zum Übertragen der jeweiligen Messwerte zu den Treiberelementen (GU1, GU2) aufweist.

8. Leistungshalbleiterkomponente (1) mit zumindest zwei spannungsgesteuerte Leistungshalbleiterbauelementen (V1, V2) und mit einer Steuereinrichtung (2) nach einem der vorhergehenden Ansprüche zum Ansteuern der zumindest zwei spannungsgesteuerten Leistungshalbleiterbauelemente (V1, V2).

9. Leistungshalbleiterkomponente (1) nach Anspruch 8, wobei die zumindest zwei Leistungshalbleiterbauelemente (V1, V2) als IGBT oder als MOSFET ausgebildet sind.

10. Verfahren zur Ansteuerung einer Leistungshalbleiterkomponente (1), wobei die Leistungshalbleiterkomponente (1) zumindest zwei spannungsgesteuerte Leistungshalbleiterbauelemente (V1, V2) aufweist, welche elektrisch parallel geschaltet sind und welche jeweils einen Steueranschluss (3) aufweisen, bei welchem mittels zumindest eines Treiberelements (GU, GU1, GU2) jeweilige elektrische Spannungen (U_{G1}, U_{G2}) an den Steueranschlüssen (3) der Leistungshalbleiterbauelemente (V1,V2) eingestellt werden, wobei mittels einer Messeinheit (5) jeweilige elektrische Ströme (I_{V1}, I_{V2}), welche durch die jeweiligen Leistungshalbleiterbauelemente (V1, V2) fließen, erfasst werden und eine Höhe und/oder ein zeitlicher Verlauf der jeweiligen elektrischen Spannungen (U_{G1}, U_{G2}) mittels des zumindest einen Treiberelements (GU, GU1, GU2) in Abhängigkeit von den jeweiligen elektrischen Strömen (I_{V1}, I_{V2}) eingestellt werden, **dadurch gekennzeichnet , dass** mittels des zumindest einen Treiberelements (GU, GU1, GU2) eine zeitliche Änderung der jeweiligen an den Steueranschlüssen (3) anliegenden elektrischen Spannungen (U_{G1}, U_{G2}) durch Anpassen einer Steilheit von Flanken der jeweiligen elektrischen Spannungen (U_{G1}, U_{G2}) bei einem Einschalten und/oder bei einem Ausschalten der Leistungshalbleiterbauelemente (V1, V2) in Abhängigkeit von den jeweiligen elektrischen Strömen (I_{V1}, I_{V2}) eingestellt wird, wobei die elektrischen Spannungen (U_{G1}, U_{G2}) beim Einschalten und/oder beim Ausschalten gerade Flanken aufweisen, wobei mittels des zumindest einen Treiberelements (GU, GU1, GU2) die jeweiligen elektrischen Spannungen (U_{G1}, U_{G2}) anhand von während eines vorhergehenden Betriebs des Leistungsmoduls (1) eingestellten Spannungen eingestellt werden, wobei die elektrischen Ströme (I_{V1}, I_{V2}), welche durch die Leistungshalbleiterbauelemente (V1, V2) bei bestimmten Einstellungen bezüglich der elektrischen Spannungen (U_{G1}, U_{G2}) fließen, gespeichert werden und die Änderung der jeweiligen elektrischen Spannungen (U_{G1}, U_{G2}) auf Grundlage der vorhergehenden Einstellungen bestimmt werden.

## Claims

1. Control device (2) for controlling a power semiconductor component (1), wherein the power semiconductor component (1) has at least two voltage-controlled power semiconductor component parts (V1, V2), which are electrically connected in parallel and which each have a control connection (3), wherein the control device (2) comprises at least one driver element (GU, GU1, GU2), by means of which respective electrical voltages (U_{G1}, U_{G2}) can be set at the control connections (3) of the power semiconductor component parts (V1, V2), wherein the control device (2) has a measuring unit (5), which is designed to detect respective electric currents (I_{V1}, I_{V2}) flowing through the respective power semiconductor component parts (V1, V2) and that the at least one driver element is designed to set an amount and/or a time curve of the respective electrical voltages (U_{G1}, U_{G2}) as a function of the respective electric currents (I_{V1}, I_{V2}), **characterised in that** the at least one driver element (GU, GU1, GU2) is designed to set a periodic change in the respective electrical voltages (U_{G1}, U_{G2}) applied at the control connections (3) by adjusting a gradient of the edges of the respective electrical voltages (U_{G1}, U_{G2}) when the power semiconductor component parts (V1, V2) are switched on and/or switched off as a function of the respective electric currents (I_{V1}, I_{V2}), wherein the electrical voltages (U_{G1}, U_{G2}) have straight edges when switched on and/or switched off, wherein the at least one driver element (GU, GU1, GU2) is designed to set the respective electrical voltages (U_{G1}, U_{G2}) on the basis of voltages set during a preceding operation of the power module (1), wherein the electrical currents (I_{V1}, I_{V2}), which flow through the power semiconductor component parts (V1, V2) with specific settings with respect to the electrical voltages (U_{G1}, U_{G2}), are stored and the at least one driver element (GU, GU1, GU2) is designed to determine the change in the respective electrical voltages (U_{G1}, U_{G2}) on the basis of the preceding settings.

2. Control device (2) according to claim 1, wherein the at least one driver element (GU, GU1, GU2) is designed to set the respective electrical voltages (U_{G1}, U_{G2}) such that the respective electric currents (I_{V1}, I_{V2}) are essentially the same.

3. Control device (2) according to claim 1 or 2, wherein the at least one driver element (GU, GU1, GU2) is designed to set respective start times (tₛ₁, tₛ₂) and end time, between which the electrical voltage (U_{G1}, U_{G2}) is applied to the control connections (3), as a function of the respective electric currents (I_{V1}, I_{V2}) .

4. Control device (2) according to one of the preceding claims, wherein the control device (2) has a driver element (GU), which has an output (4, 4') and at least one input (7, 7') for each of the power semiconductor component parts (V1, V2) for receiving measured values, which describe the respective electric currents (I_{V1}, I_{V2}).

5. Control device (2) according to one of claims 1 to 3, wherein the control device (2) has a driver element (GU1, GU2) for each of the power semiconductor component parts (V1, V2), wherein each of the driver elements (GU1, UG2) has an output (4) for the power semiconductor component part (V1, V2).

6. Control device (2) according to claim 5, wherein each of the driver elements (GU1, GU2) has an input (7) for receiving a measured value, which describes the electric current (I_{V1}, I_{V2}) through the power semiconductor component part (V1, V2), and wherein the control device (2) has at least one communication unit (8) for transmitting the respective measured values between the driver elements (GU1, GU2).

7. Control device (2) according to claim 5, wherein the control device (2) has a central computing unit (9) for receiving measured values, which describe the respective electric currents (I_{V1}, I_{V2}), and at least one communication unit (8) for transmitting the respective measured values to the driver elements (GU1, GU2).

8. Power semiconductor component (1) with at least two voltage-controlled power semiconductor component parts (V1, V2) and with a control device (2) according to one of the preceding claims for controlling the at least two voltage-controlled power semiconductor component parts (V1, V2).

9. Power semiconductor component (1) according to claim 8, wherein the at least two power semiconductor component parts (V1, V2) are embodied as an IGBT or as a MOSFET.

10. Method for controlling a power semiconductor component (1), wherein the power semiconductor component (1) has at least two voltage-controlled power semiconductor component parts (V1, V2), which are electrically connected in parallel and which each have a control connection (3), in which at least one driver element (GU, GU1, UG2) is used to set respective electrical voltages (U_{G1}, U_{G2}) at the control connections (3) of the power semiconductor component parts (V1, V2), wherein a measuring unit (5) is used to detect respective electric currents (I_{V1}, I_{V2}) flowing through the respective power semiconductor component parts (V1, V2) and an amount and/or a time curve of the respective electrical voltages (U_{G1}, U_{G2}) are set by means of the at least one driver element (GU, GU1, GU2) as a function of the respective electric currents (I_{V1}, I_{V2}), **characterised in that** the at least one driver element (GU, GU1, GU2) is used to set a periodic change in the respective electrical voltages (U_{G1}, U_{G2}) applied to the control connections (3) by adjusting a gradient of the edges of the respective electrical voltages (U_{G1}, U_{G2}) when the power semiconductor component parts (V1, V2) are switched on and/or switched off as a function of the respective electric currents (I_{V1}, I_{V2}), wherein the electrical voltages (U_{G1}, U_{G2}) have straight edges when switched on and/or switched off, wherein the at least one driver element (GU, GU1, GU2) is used to set the respective electrical voltages (U_{G1}, U_{G2}) on the basis of voltages set during a preceding operation of the power module (1), wherein the electrical currents (I_{V1}, I_{V2}), which flow through the power semiconductor component parts (V1, V2) with specific settings with respect to the electrical voltages (U_{G1}, U_{G2}), are stored and the change in the respective electrical voltages (U_{G1}, U_{G2}) is determined on the basis of the preceding settings.

## Revendications

1. Dispositif (2) de commande pour commander un composant (1) à semi-conducteur de puissance, dans lequel le composant (1) à semi-conducteur de puissance a au moins deux éléments (V1, V2) à semi-conducteur de puissance commandés par la tension, qui sont montés en parallèle électriquement et qui ont chacun une borne (3) de commande, le dispositif (2) de commande comprenant au moins un élément (GU, GU1, GU2) d'excitation, au moyen duquel des tensions (U_{G1}, U_{G2}) électriques respectives peuvent être réglées aux bornes (3) de commande des éléments (V1, V2) à semi-conducteur de puissance, le dispositif (2) de commande ayant une unité (5) de mesure conçue pour relever des courants (I_{V1}, I_{V2}) électriques respectifs, qui passent dans les éléments (V1, V2) à semi-conducteur de puissance respectifs, et en ce que le au moins un élément d'excitation est conçu pour régler un niveau et/ou une courbe dans le temps des tensions (U_{G1}, U_{G2}) électriques respectives en fonction des courants (I_{V1}, I_{V2}) électriques respectifs, **caractérisé en ce que** le au moins un élément (GU, GU1, GU2) d'excitation est conçu pour régler, en fonction des courants (I_{V1}, I_{V2}) électriques respectifs, une variation dans le temps des tensions (U_{G1}, U_{G2}) électriques appliquées aux bornes (3) de commande, par adaptation d'une pente de fronts des tensions (U_{G1}, U_{G2}) électriques respectives lors d'une mise en circuit et/ou d'une mise hors circuit des éléments (V1, V2) à semi-conducteur de puissance, les tensions (U_{G1}, U_{G2}) électriques ayant, lors de la mise en circuit et/ou de la mise hors circuit, des fronts rectilignes, le au moins un élément (GU, GU1, GU2) d'excitation étant conçu pour régler les tensions (U_{G1}, U_{G2}) électriques respectives à l'aide de tensions réglées pendant un fonctionnement précédent du module (1) de puissance, les courants (I_{V1}, I_{V2}) électriques, qui passent dans les éléments (V1, V2) à semi-conducteur de puissance pour des réglages déterminés se rapportant aux tensions (U_{G1}, U_{G2}) électriques, étant mis en mémoire et le au moins un élément (GU, GU1, GU2) d'excitation étant conçu pour déterminer la variation des tensions (U_{G1}, U_{G2}) électriques respectives sur la base des réglages précédents.

2. Dispositif (2) de commande suivant la revendication 1, dans lequel le au moins un élément (GU, GU1, GU2) d'excitation est conçu pour régler les tensions (U_{G1}, U_{G2}) électriques respectives de manière à ce que les courants (I_{V1}, I_{V2}) électriques respectifs soient sensiblement égaux.

3. Dispositif (2) de commande suivant la revendication 1 ou 2, dans lequel le au moins un élément (GU, GU1, GU2) d'excitation est conçu pour régler des instants (tₛ₁, tₛ₂) de début et des instants de fin respectifs, entre lesquels la tension (U_{G1}, U_{G2}) électrique s'applique aux bornes (3) de commande, en fonction des courants (I_{V1}, I_{V2}) électriques respectifs.

4. Dispositif (2) de commande suivant l'une des revendications précédentes, dans lequel le dispositif (2) de commande a un élément (GU) d'excitation, qui a, pour chacun des éléments (V1, V2) à semi-conducteur de puissance, une sortie (4, 4') et au moins une entrée (7, 7') de réception de valeurs de mesure, qui décrivent les courants (I_{V1}, I_{V2}) électriques respectifs.

5. Dispositif (2) de commande suivant l'une des revendications 1 à 3, dans lequel le dispositif (2) de commande a, pour chacun des éléments (V1, V2) à semi-conducteur de puissance, un élément (GU1, GU2) d'excitation, chacun des éléments (GU1, GU2) d'excitation ayant une sortie (4) pour l'élément (V1, V2) à semi-conducteur de puissance.

6. Dispositif (2) de commande suivant la revendication 5, dans lequel chacun des éléments (GU1, GU2) d'excitation a une entrée (7) de réception de valeurs de mesure, qui décrivent le courant (I_{V1}, I_{V2}) électrique passant dans l'élément (V1, V2) à semi-conducteur de puissance, et dans lequel le dispositif (2) de commande a au moins une unité (8) de communication pour la transmission de valeurs de mesure respectives entre les éléments (GU1, GU2) d'excitation.

7. Dispositif (2) de commande suivant la revendication 5, dans lequel le dispositif (2) de commande a une unité (9) informatique centrale de réception de valeurs de mesure, qui décrivent les courants (I_{V1}, I_{V2}) électriques respectifs, et au moins une unité (8) de communication pour la transmission des valeurs de mesure respectives aux éléments (GU1, GU2) d'excitation.

8. Composant (1) à semi-conducteur de puissance ayant au moins deux éléments (V1, V2) à semi-conducteur de puissance commandés par la tension et comprenant un dispositif (2) de commande suivant l'une des revendications précédentes pour la commande des au moins deux éléments (V1, V2) à semi-conducteur de puissance commandés par la tension.

9. Composant (1) à semi-conducteur de puissance suivant la revendication 8, dans lequel les au moins deux éléments (V1, V2) à semi-conducteur de puissance sont constitués sous la forme d'IGBT ou de MOSFET.

10. Procédé de commande d'un composant (1) à semi-conducteur de puissance, le composant (1) à semi-conducteur de puissance ayant au moins deux éléments (V1, V2) à semi-conducteur de puissance commandés par la tension, qui sont montés en parallèle électriquement et qui ont chacun une borne (3) de commande, dans lequel, au moyen d'au moins un élément (GU, GU1, GU2) d'excitation, on règle les tensions (U_{G1}, U_{G2}) électriques respectives aux bornes (3) de commande des éléments (V1, V2) à semi-conducteur de puissance, dans lequel on relève, au moyen d'une unité (5) de mesure, des courants (I_{V1}, I_{V2}) électriques respectifs, qui passent dans les éléments (V1, V2) à semi-conducteur de puissance, et on règle, en fonction des courants (I_{V1}, I_{V2}) électriques respectifs, un niveau et/ou une courbe dans le temps des tensions (U_{G1}, U_{G2}) électriques respectives, au moyen du au moins un élément (GU, GU1, GU2) d'excitation, **caractérisé en ce qu'**au moyen du au moins un élément (GU, GU1, GU2) d'excitation, on règle, en fonction des courants (I_{V1}, I_{V2}) électriques respectifs, une variation dans le temps des tensions (U_{G1}, U_{G2}) électriques respectives s'appliquant aux bornes (3) de commande, en adaptant une pente de fronts des tensions (U_{G1}, U_{G2}) électriques respectives lors d'une mise en circuit et/ou d'une mise hors circuit des éléments (V1, V2) à semi-conducteur de puissance, les tensions (I_{G1}, U_{G2}) électriques ayant des fronts rectilignes lors de la mise en circuit et/ou de la mise hors circuit, dans lequel, au moyen du au moins un élément (GU, GU1, GU2) d'excitation, on règle des tensions (U_{G1}, U_{G2}) électriques respectives à l'aide de tensions réglées pendant un fonctionnement précédent du module (1) de puissance, dans lequel on met en mémoire les courants (I_{V1}, I_{V2}) électriques, qui passent dans les éléments (V1, V2) à semi-conducteur de puissance lors de réglages déterminés rapportés aux tensions (U_{G1}, U_{G2}) électriques et on détermine la variation des tensions (UG1, U_{G2}) électriques respectives sur la base des réglages précédents.
